(19) Europäisches Patentamt
European Patent Office
Office européen des brevets

(11) **EP 3 079 260 B1**

(12) **FASCICULE DE BREVET EUROPEEN**

(45) Date de publication et mention
de la délivrance du brevet:
**15.01.2020 Bulletin 2020/03**

(51) Int Cl.:
**H03K 19/00** *(2006.01)* **H03K 19/017** *(2006.01)*
**H03K 19/0948** *(2006.01)* **H03K 19/0944** *(2006.01)*

(21) Numéro de dépôt: **16164459.6**

(22) Date de dépôt: **08.04.2016**

(54) **PROCEDE ET DISPOSITIF D'AUTO-CALIBRATION DE CIRCUITS MULTI-GRILLES**

VERFAHREN UND VORRICHTUNG ZUR AUTOMATISCHEN KALIBRIERUNG VON
MULTI-GRID-SCHALTKREISEN

METHOD AND DEVICE FOR SELF-CALIBRATION OF MULTI-GATE CIRCUITS

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **10.04.2015 FR 1553096**

(43) Date de publication de la demande:
**12.10.2016 Bulletin 2016/41**

(73) Titulaires:
  • **Université de Nice
    06103 Nice Cedex 2 (FR)**
  • **COMMISSARIAT À L'ÉNERGIE ATOMIQUE ET
    AUX
    ÉNERGIES ALTERNATIVES
    75015 Paris (FR)**

(72) Inventeurs:
  • **JACQUEMOD, Gilles Fernand
    06600 Antibes (FR)**

  • **DE FOUCAULD, Emeric
    38500 Coublevie (FR)**
  • **FONSECA, Alexandre Benjamin
    83440 Seillans (FR)**
  • **LEDUC, Yves
    06630 Roquefort-les-Pins (FR)**
  • **LORENZINI, Philippe Bernard Pierre
    06600 Antibes (FR)**

(74) Mandataire: **Lopez, Frédérique et al
Marks & Clerk France
Immeuble Visium
22 Avenue Aristide Briand
94117 Arcueil Cedex (FR)**

(56) Documents cités:
**EP-A2- 1 744 364      WO-A1-2012/045874
US-A1- 2007 262 793**

## Description

### Domaine de l'invention

L'invention se situe dans le domaine des circuits intégrés, et en particulier celui des circuits multi-grilles de type FinFET ou FDSOI.

### Etat de la Technique

Chaque année, de nouvelles technologies microélectroniques sont disponibles, apportant des innovations et des améliorations à notre quotidien. Tout cela est possible grâce à des circuits aux performances de plus en plus élevées et des fonctions de plus en plus complexes. Cette augmentation de performances a été rendue possible par la miniaturisation des composants élémentaires, à savoir les transistors. Les technologies actuelles permettent de concevoir des puces ayant des transistors aux dimensions atomiques. Au fur et à mesure que la taille des transistors est réduite vers la dizaine de nanomètres, la variation des dopants dans la région du canal cause directement une variation de la tension de seuil $V_{TH}$ entre deux transistors supposés identiques et adjacents sur une même puce. De nouvelles structures de transistors MOSFET ont été récemment proposées pour réduire la variabilité des composants en dessous de 22nm, les unes selon la technologie FinFet qui utilise des transistors non-planaires multi-grilles, et d'autres selon la technologie FDSOI « Fully Depleted Silicium On Insulator ».

La technologie FDSOI (Fully Depleted Silicon on Insulator - silicium complètement appauvri sur isolant) est basée sur une mince couche (5 à 20nm) de silicium sur une mince couche (5 à 50nm) d'oxyde enterré (Buried Oxide -BOx). Les transistors sont construits sur la fine couche de silicium non-dopée (appauvrie en charges) qui a plusieurs avantages par rapport au Bulk. Comme le canal est complètement appauvri, la variation aléatoire des dopants qui touchait le CMOS Bulk est réduite, ce qui améliore les performances à VDD plus faible. Le FDSOI revendique une amélioration du ratio Consommation/Performance de l'ordre de 30 à 40% face au CMOS Bulk 20nm.

Cependant, la variabilité des procédés de fabrication reste contraignante pour les circuits intégrés et elle introduit des désappariements des transistors. Ainsi sur une même puce, des transistors supposés identiques ne vont pas avoir les mêmes caractéristiques. Cette différence de caractéristiques peut introduire des dysfonctionnements du circuit final, qui peut alors ne plus vérifier pour certaines applications, les spécifications demandées.

Dans le cas spécifique de l'électronique analogique, certaines cellules nécessitent que les transistors soient identiques, c'est-à-dire appairés. Des techniques de calibration des circuits sont devenues nécessaires pour une majorité d'applications.

Cependant, les approches connues de mise en œuvre de la calibration conduisent à une augmentation de la surface du circuit final par ajout d'électronique, donc à une augmentation de la consommation et à une augmentation du coût global.

Aussi un problème à résoudre est celui de proposer une solution de calibration des circuits qui n'augmente pas la surface du circuit, et qui présente une immunité à la variabilité des procédés.

La technologie FDSOI qui n'a pas besoin de dopage pour contrôler la tension de seuil, et qui offre par ailleurs sur les transistors une grille arrière, permet de proposer une solution de calibration basée sur la commande de la grille arrière des transistors.

Cependant, dans le cas des circuits analogiques différentiels, tels les miroirs de courant ou les paires différentielles, il est important que les transistors aient les mêmes caractéristiques. De même, pour réaliser des oscillateurs, notamment des oscillateurs en anneau à base d'inverseurs, il est également important que les transistors (donc les inverseurs) aient les mêmes caractéristiques pour diminuer le phénomène de gigue (« jitter » en anglais). Or, il n'existe pas en technologie FDSOI de solution simple connue à ce problème.

Le document US 2007/262793 A1 décrit un circuit logique différentiel à base de quatre transistors JFET constituant une cellule flip-flop qui a deux entrées et deux points mémoire appliqués sur la grille arrière de deux des dits transistors respectivement.

Il existe alors le besoin d'une solution qui pallie aux inconvénients des approches connues. La présente invention répond à ce besoin. Cette invention s'applique à tous les circuits numériques utilisant une logique complémentaire.

### Résumé de l'invention

Un objet de la présente invention est de proposer un circuit en logique complémentaire selon la revendication 1. En particulier, un circuit en logique différentielle apte à être chaîné avec un autre circuit en logique différentielle ayant la même configuration, comprend : une première cellule logique composée de transistors à grille arrière, la première cellule ayant au moins une première entrée pour recevoir au moins un premier signal d'entrée et ayant une sortie pour délivrer un premier signal de sortie, et une deuxième cellule logique complémentaire de la première cellule, composée de transistors à grille arrière, la deuxième cellule ayant autant d'entrées que la première cellule, chaque entrée pouvant recevoir un signal d'entrée complémentaire du signal d'entrée respectif de la première cellule, la deuxième cellule ayant une sortie pour délivrer un deuxième signal de sortie complémentaire du premier signal de sortie de la première cellule. Le circuit est caractérisé en ce que ledit premier signal de sortie de la première cellule est appliqué sur la grille arrière de chaque transistor de la deuxième cellule, et ledit deuxième signal de sortie de la deuxième cellule est appliqué sur la grille arrière de chaque transistor de la première cellule, et en ce que le premier signal de sortie de la première cellule est connecté à une entrée d'une première cellule logique d'un autre circuit en logique différentielle de même configuration que le circuit en logique différentielle, et le deuxième signal de sortie de la deuxième cellule est connecté à une entrée d'une deuxième cellule logique de cet autre circuit en logique différentielle.

Différents modes de réalisation apparaissent dans la description et les revendications dépendantes.

## Description des figures

Différents aspects et avantages de l'invention vont apparaitre en appui de la description d'un mode préféré d'implémentation de l'invention mais non limitatif, avec référence aux figures ci-dessous :

La figure 1 est une représentation en logique conventionnelle d'un inverseur et de sa réalisation en utilisant les différentes polarisations possible de la grille arrière des 2 transistors la composant ;
La figure 2 est une représentation en logique complémentaire d'une cellule inverseur selon un mode de réalisation de l'invention ;
La figure 3 montre une implémentation préférentielle de la cellule inverseur de la figure 2 selon un mode de réalisation ;
La figure 4 montre une variante d'implémentation de la cellule inverseur de la figure 2 dans un autre mode de réalisation de l'invention ;
La figure 5 montre un oscillateur en anneau dans un mode de réalisation de l'invention ;
La figure 6 montre un exemple d'implémentation d'une fonction NAND à deux entrées selon un mode de réalisation de l'invention ;
Les figures 7a à 7e illustrent des exemples d'implémentations de fonctions logiques selon des modes de réalisation de l'invention.

## Description détaillée de l'invention

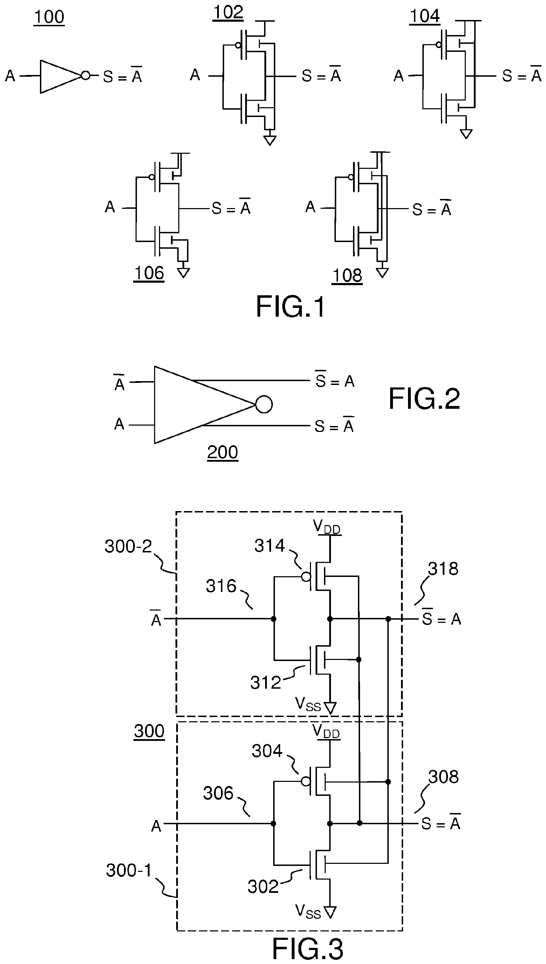

Référence est faite à la figure 1 où une représentation conventionnelle logique 100 d'un circuit inverseur ayant une entrée 'I=A' et délivrant une sortie complémentaire 'S=$\overline{A}$' est montrée. Quelques exemples d'implémentations d'un tel inverseur dans une technologie de transistors à grille arrière, telle la technologie CMOS FDSOI sont illustrés, où les grilles arrières des transistors peuvent être connectées à des mêmes tensions (102, 104) ou à des tensions différentes (106, 108). Cependant, ces exemples sont non limitatifs et les principes de l'invention peuvent s'appliquer sur d'autres technologies proposant des transistors dissymétriques ayant des grilles asymétriques.

La figure 2 illustre, sur une représentation d'un circuit inverseur, le principe général de l'invention qui est de symétriser le fonctionnement du circuit selon une logique complémentaire. Le circuit inverseur 200 de l'invention comprend une entrée complémentaire et une sortie complémentaire. L'entrée du circuit reçoit un premier signal 'A' et un deuxième signal '$\overline{A}$' complémentaire du premier signal. La sortie complémentaire délivre un premier signal 'S=$\overline{A}$' inverse du premier signal d'entrée 'A', et un deuxième signal complémentaire 'S=A', inverse du deuxième signal d'entrée. Les transistors du circuit sont de type ayant une grille arrière, en technologie SOI, FDSOI, ou encore CMOS avec bulk, double-puits ou triple-puits. Les transistors peuvent aussi être de type double grille en technologie FinFet, ou toute autre technologie offrant sur un transistor une grille permettant de contrôler la tension de seuil du transistor. Selon le principe de l'invention, les caractéristiques des transistors sont modifiées en fonction des caractéristiques de la sortie du circuit en modifiant la valeur sur la grille arrière ou la double grille des transistors. Le signal de sortie est un signal complémentaire symétrisé grâce à un contrôle des tensions de seuil des transistors.

La figure 3 montre un exemple d'implémentation du circuit inverseur de la figure 2 en technologie CMOS FDSOI. D'une manière générale, le circuit 300 comprend une première cellule 300-1 pour recevoir sur une première entrée un premier signal d'entrée 'A' et délivrer sur une première sortie, un premier signal de sortie 'S'. Il comprend une deuxième cellule 300-2 en logique complémentaire pour recevoir sur une deuxième entrée un deuxième signal d'entrée '$\overline{A}$' complémentaire du premier signal d'entrée, et délivrer sur une deuxième sortie, un deuxième signal de sortie 'S' qui est complémentaire du premier signal de sortie de la première cellule. Les transistors des première et deuxième cellules ayant des grilles arrières, le principe nouveau et inventif de la présente invention consiste en ce que la sortie de chaque cellule est rebouclée sur la grille arrière de tous les transistors réalisant la fonction logique de l'autre cellule. Ainsi, la sortie de la première cellule est appliquée sur les grilles arrière des transistors de la deuxième cellule, et la sortie de la deuxième cellule est appliquée sur la grille arrière des transistors de la première cellule. Il y a alors une symétrisation des deux étages du circuit inverseur qui s'effectue et de ce fait, les effets liés à la variabilité du procédé vont s'atténuer.

Avantageusement, les signaux complémentaires reçus sur les entrées complémentaires présentant des transitions sensiblement simultanées, et de par des temps de propagation dans le circuit sensiblement égaux du fait de l'agencement des transistors, les signaux de sortie présentent des transitions sensiblement simultanées.

Dans le détail de l'implémentation de la figure 3, la première cellule 300-1 de l'inverseur 300, comprend un transistor 302 de type NMOS, un transistor 304 de type PMOS, une entrée 306 pour recevoir un signal de valeur 'A' et une sortie 308 pour délivrer un signal de valeur inversée '$\overline{A}$'. Dans l'exemple décrit les transistors (302, 304) sont de type FDSOI et comprennent une grille arrière qui est connectée à la sortie 318 de la deuxième cellule. De manière symétrique, la deuxième cellule 300-2 de l'inverseur 300, comprend un transistor 312 de type NMOS, un transistor 314 de type PMOS, une entrée 316 pour recevoir un signal de valeur '$\overline{A}$' complémentaire de la valeur 'A' de la première cellule, et une sortie 318 pour délivrer un signal de valeur inversée 'A', qui est complémentaire de la valeur de sortie de la première cellule. De manière similaire à la première cellule, les transistors (312, 314) sont de type FDSOI et comprennent une grille arrière qui est connectée à la sortie 308 de la première cellule. En fonctionnement, lorsque la sortie 'S' de l'inverseur de la deuxième cellule 300-2 commute du haut vers le bas (i.e. l'entrée a commuté du bas vers le haut, de $V_{SS}$ à $V_{DD}$), c'est le transistor NMOS 312 qui conduit. Pendant le même temps la sortie 'S' de l'inverseur de la première cellule commute du bas vers le haut, et c'est le transistor PMOS 304 qui conduit. De fait, avantageusement en rebouclant les sorties de chaque cellule sur la grille arrière des transistors de l'autre cellule, la cellule la plus lente va ralentir la plus rapide et la plus rapide va accélérer la plus lente. Le rebouclage des sorties compense alors une grande partie des déséquilibres entre les temps de propagation. Ainsi les temps de propagation « $tp_{HL}$ » et « $tp_{LH}$ » au sein du circuit 300 vont s'équilibrer (se compenser ou se calibrer). Néanmoins, le choix des transistors, notamment leur dimensionnement permet encore d'affiner l'équilibrage des temps de propagation.

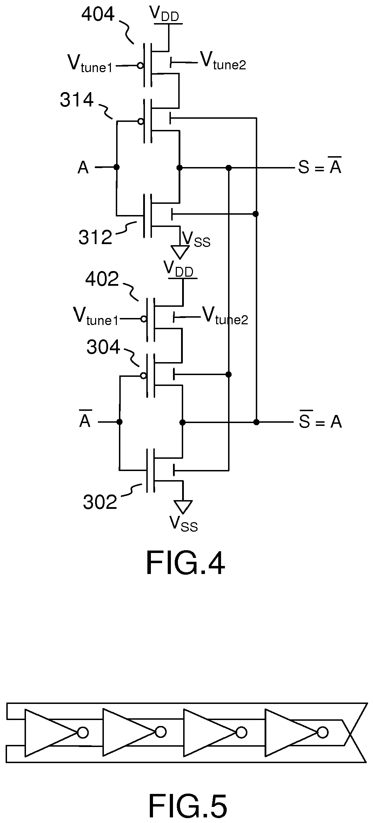

L'homme du métier comprend que les transistors sont connectés à des sources de tensions hautes et basses ($V_{DD}$, $V_{SS}$) qu'il n'est pas utile de plus décrire, et que différentes implémentations de l'exemple décrit peuvent être réalisées selon que les transistors sont connectés directement à la tension d'alimentation ou via un générateur de courant par exemple comme illustré sur la figure 4. Il est à noter que les éléments identiques à ceux de la figure 3 conservent les mêmes références, comme les transistors (302, 304) et (312, 314) de chaque cellule inverseur.

La figure 4 montre un circuit inverseur dans un mode de réalisation de l'invention comprenant un générateur de courant commandé dans chaque cellule inverseur. Le générateur de courant est composé d'un transistor (402, 404) placé entre le transistor PMOS (304, 314) de chaque cellule et l'alimentation $V_{DD}$ et commandé par une tension définie '$V_{tune1}$'. Dans une variante d'implémentation, un deuxième générateur de courant peut être ajouté par un transistor placé entre le transistor NMOS (302, 312) et la tension basse $V_{SS}$.

Grâce à la grille arrière des transistors montés en générateur de courant, il est possible pour un réglage plus fin ou une calibration supplémentaire de polariser cette électrode par l'intermédiaire d'une tension définie '$V_{tune2}$'.

Avantageusement, puisque l'invention propose la réalisation de portes logiques complémentaires, un tel dispositif permet de réaliser un circuit oscillateur en anneau dont le rapport cyclique va tendre vers 50%, ce qui est très important pour nombres d'applications en télécommunication. Toujours avantageusement, le principe de la présente invention permet de réaliser des circuits oscillateurs commandés par la tension (VCO) ayant un nombre pair d'inverseurs comme illustré sur la figure 5, où la commande du VCO correspond à la tension '$V_{tune1}$'.

Dans une implémentation avantageuse, un tel oscillateur avec un nombre pair d'inverseurs permet de réaliser un oscillateur en quadrature (QVCO) présentant 4 sorties de même amplitude et même fréquence, mais à des phases différentes régulièrement réparties (0°, 90°, 180° et 270°). Cette topologie de VCO en quadrature (QVCO) est avantageusement utilisée dans des architectures de récepteurs radiofréquences à réjection de fréquence image.

D'une manière plus générale, le principe de l'invention peut être étendu et appliqué à toutes les cellules numériques utilisant une logique complémentaire. De plus, les cellules logiques conçues selon le principe de l'invention ont vocation à être chaînées, combinées, pour concevoir des systèmes logiques étendus. Un tel système étendu peut réaliser une fonction logique générale, elle-même décomposable en fonctions logiques élémentaires, chaque fonction logique élémentaire pouvant être réalisée par une cellule logique de base.

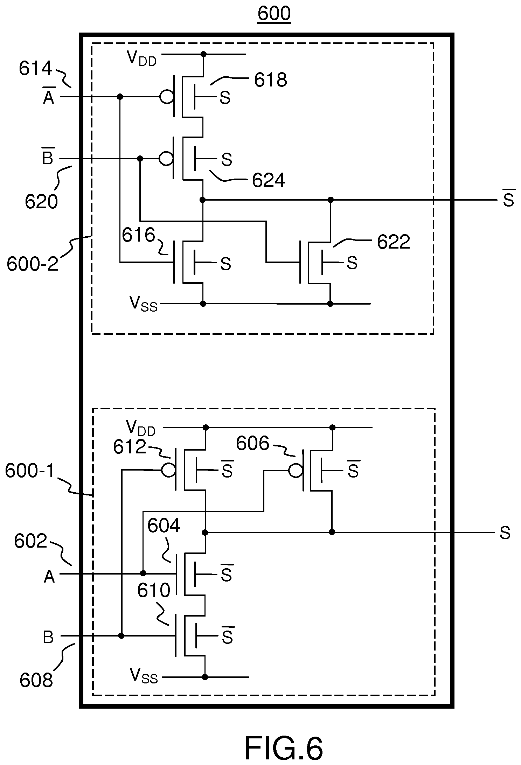

La figure 6 montre un exemple d'implémentation d'une fonction NAND à deux entrées (NAND2) selon un mode de réalisation de l'invention en technologie FDSOI. Le circuit 600 est composé d'une première cellule 600-1 et d'une deuxième cellule complémentaire 600-2. Chaque cellule comprend des transistors permettant de réaliser une fonction NAND à deux entrées. Selon le principe de l'invention, la sortie de chaque cellule est rebouclée sur la grille arrière des transistors de l'autre cellule, rendant ainsi les cellules plus robustes aux variations technologiques du procédé de fabrication et aux aléas de fonctionnement (notamment pour la synthèse de circuits asynchrones).

La première cellule NAND comprend une première entrée 602 pour recevoir un premier signal 'A' appliqué sur l'entrée de deux transistors NMOS 604 et PMOS 606. La première cellule NAND comprend de plus une deuxième entrée 608 pour recevoir un deuxième signal 'B' appliqué sur l'entrée de deux transistors NMOS 610 et PMOS 612.

La deuxième cellule 600-2 réalisant la porte NAND complémentaire, comprend une première entrée 614, pour recevoir un premier signal '$\overline{A}$' complémentaire du premier signal de la première cellule, et appliqué sur l'entrée de deux transistors NMOS 616 et PMOS 618. La deuxième cellule comprend aussi une deuxième entrée 620 pour recevoir un deuxième signal '$\overline{B}$' complémentaire du deuxième signal 'B' de la première cellule, et appliqué sur l'entrée de deux transistors NMOS 610 et PMOS 612.

La première cellule NAND 600-1 permet de délivrer un signal de sortie 'S' correspondant à la fonction NAND des entrées 'A' et 'B'. La deuxième cellule complémentaire 600-2 permet de délivrer un signal de sortie '$\overline{S}$' correspondant à la fonction NAND des entrées '$\overline{A}$' et '$\overline{B}$'. La sortie 'S' de la première cellule est appliqué sur la grille arrière de tous les transistors (616, 618, 622, 624) de la deuxième cellule, et la sortie $\overline{S}$ de la deuxième cellule est appliquée sur la grille arrière de tous les transistors (604, 606, 610, 612) de la première cellule. La sortie logique du circuit différentiel NAND2 selon le principe de l'invention est alors :

$$\{S,\overline{S}\} = \{A,\overline{A}\}.\{B,\overline{B}\} \;\rightarrow\; S = \overline{A.B} \;(\text{NAND}) \text{ et } \overline{S} = \overline{\overline{A.B}} = \overline{\overline{A}+\overline{B}} \;(\text{NOR})$$

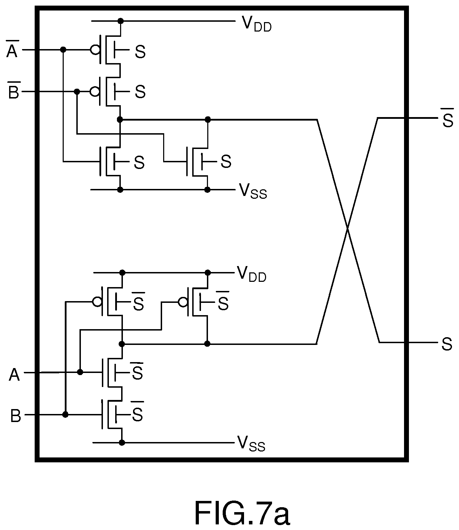

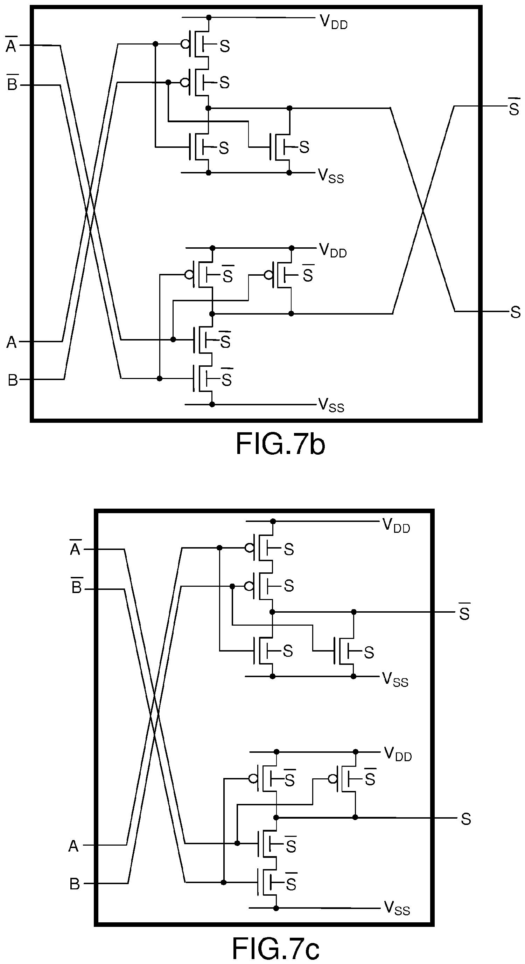

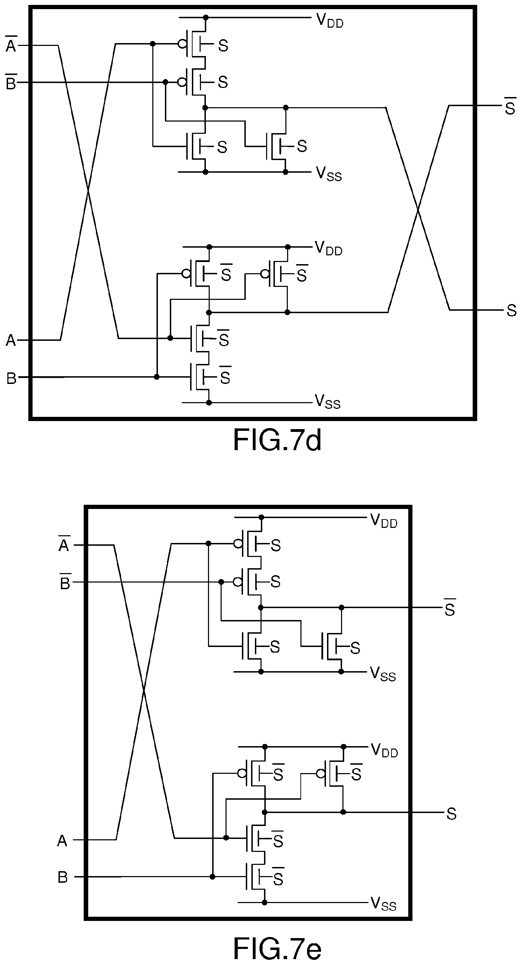

Les figures 7a à 7e illustrent des exemples d'implémentations de circuits en logique complémentaire selon des modes de réalisation de l'invention. La figure 7a illustre un circuit différentiel composé de deux cellules symétriques pour réaliser une fonction AND à deux entrées. La figure 7b illustre un circuit différentiel composé de deux cellules symétriques pour réaliser une fonction NOR à deux entrées. La figure 7c illustre un circuit différentiel composé de deux cellules symétriques pour réaliser une fonction OR à deux entrées. Les cellules des figures 7d et 7e réalisent d'autres fonctions logiques à deux entrées.

Ainsi, la présente description illustre une implémentation préférentielle de l'invention, mais n'est pas limitative. Quelques exemples ont été décrits pour permettre une bonne compréhension des principes de l'invention, et une application concrète, mais ils ne sont en rien exhaustifs et doivent permettre à l'homme du métier d'apporter des modifications et des variantes d'implémentation en conservant les mêmes principes.

**Revendications**

1. Un circuit en logique différentielle apte à être chaîné avec un autre circuit en logique différentielle ayant la même configuration, comprenant :

   - une première cellule logique composée de transistors à grille arrière, la première cellule ayant au moins une première entrée pour recevoir au moins un premier signal d'entrée (A) et ayant une sortie pour délivrer un premier signal de sortie (S) ; et
   - une deuxième cellule logique complémentaire de la première cellule, composée de transistors à grille arrière, la deuxième cellule ayant autant d'entrées que la première cellule, chaque entrée pouvant recevoir un signal d'entrée ($\overline{A}$) complémentaire du signal d'entrée respectif de la première cellule, la deuxième cellule ayant une sortie pour délivrer un deuxième signal de sortie ($\overline{S}$) complémentaire du premier signal de sortie (S) de la première cellule;

   ledit premier signal de sortie (S) de la première cellule étant appliqué sur la grille arrière de chaque transistor de la deuxième cellule et ledit deuxième signal de sortie ($\overline{S}$) de la deuxième cellule étant appliqué sur la grille arrière de chaque transistor de la première cellule ;
   le circuit étant **caractérisé en ce que** ledit premier signal de sortie (S) de la première cellule est connecté à une entrée d'une première cellule logique d'un autre circuit en logique différentielle de même configuration que ledit circuit en logique différentielle ; et
   ledit deuxième signal de sortie ($\overline{S}$) de la deuxième cellule est connecté à une entrée d'une deuxième cellule logique de cet autre circuit en logique différentielle.

2. Le circuit selon la revendication 1 dans lequel les transistors sont des transistors à grille arrière asymétrique.

3. Le circuit selon la revendication 2 dans lequel les transistors sont de type CMOS.

4. Le circuit selon la revendication 1 dans lequel la première cellule est un premier inverseur CMOS apte à délivrer une sortie inverse de son entrée, et la deuxième cellule est un deuxième inverseur CMOS apte à recevoir une entrée complémentaire de l'entrée du premier inverseur et à délivrer une sortie complémentaire de la sortie du premier inverseur, la sortie du premier inverseur étant appliquée sur la grille arrière des transistors NMOS et PMOS du deuxième inverseur CMOS et la sortie complémentaire du deuxième inverseur étant appliquée sur la grille arrière des transistors NMOS et PMOS du premier inverseur CMOS.

5. Le circuit selon la revendication 4 dans lequel le premier inverseur et le second inverseur sont connectés directement entre une tension haute et une tension basse.

6. Le circuit selon la revendication 4 dans lequel le premier inverseur et le second inverseur comprennent un générateur de courant entre le transistor PMOS et une tension haute.

7. Le circuit selon la revendication 5 ou 6 dans lequel le premier inverseur et le second inverseur comprennent un générateur de courant entre le transistor NMOS et une tension basse.

8. Un système comprenant plusieurs circuits selon l'une quelconque des revendications 1 à 7, lesdits plusieurs circuits étant couplés en chaîne de sorte que les sorties d'un circuit de la chaîne sont connectées aux entrées du circuit suivant dans la chaîne.

9. Un système selon la revendication 8 dans lequel les signaux d'entrée présentent des transitions sensiblement simultanées, les temps de propagation sont sensiblement égaux et les signaux de sortie présentent des transitions sensiblement simultanées.

10. Le système selon la revendication 8 ou 9 comprenant un nombre pair de circuits, le système réalisant un oscillateur contrôlé par la tension.

11. Le système selon la revendication 10 comprenant quatre sorties identiques de même amplitude, de même fréquence et de phases régulièrement réparties.

12. Le circuit selon la revendication 1 dans lequel la première cellule comprend des transistors CMOS aptes à réaliser une fonction AND de deux entrées (A,B) et la deuxième cellule comprend des transistors CMOS aptes à réaliser une fonction AND des deux entrées complémentaires (A,B) de la première cellule.

13. Le circuit selon la revendication 1 dans lequel la première cellule comprend des transistors CMOS aptes à réaliser une fonction NAND de deux entrées (A,B) et la deuxième cellule comprend des transistors CMOS aptes à réaliser une fonction NAND des deux entrées complémentaires (A,B) de la première cellule.

14. Le circuit selon la revendication 1 dans lequel la première cellule comprend des transistors CMOS aptes à réaliser une fonction OR de deux entrées (A,B) et la deuxième cellule comprend des transistors CMOS aptes à réaliser une fonction OR des deux entrées complémentaires (A,B) de la première cellule.

15. Le circuit selon la revendication 1 dans lequel la première cellule comprend des transistors CMOS aptes à réaliser une fonction NOR de deux entrées (A,B) et la deuxième cellule comprend des transistors CMOS aptes à réaliser une fonction NOR des deux entrées complémentaires (A,B) de la première cellule.

16. Le circuit selon l'une quelconque des revendications 1 à 7 et 12 à 15 dans lequel les transistors sont des transistors en technologie silicium complètement appauvri sur isolant «FDSOI».

17. Le circuit selon l'une quelconque des revendications 1 à 7 et 12 à 15 dans lequel les transistors sont des transistors« FinFet» à double grille.

**Patentansprüche**

1. Schaltkreis mit Differenziallogik, welcher in der Lage ist, mit einem anderen Schaltkreis mit Differenziallogik mit gleicher Konfiguration verkettet zu werden, Folgendes beinhaltend:

   - eine erste logische Zelle, bestehend aus Transistoren mit rückwärtigem Gate, wobei die erste Zelle mindestens einen ersten Eingang besitzt, um mindestens ein erstes Eingangssignal (A) zu empfangen und einen Ausgang besitzt, um ein erstes Ausgangssignal (S) abzugeben; und
   - eine zweite logische Zelle, welche zu der ersten Zelle komplementär ist, bestehend aus Transistoren mit rückwärtigem Gate, wobei die zweite Zelle ebenso viele Eingänge wie die erste Zelle besitzt, wobei jeder Eingang ein Eingangssignal ($\overline{A}$) empfangen kann, welches komplementär zu dem jeweiligen Eingangssignal der ersten Zelle ist, wobei die zweite Zelle einen Ausgang zum Abgeben eines zweiten Ausgangssignals ($\overline{S}$) besitzt, welches komplementär zum ersten Ausgangssignal (S) der ersten Zelle ist;

wobei das erste Ausgangssignal (S) der ersten Zelle an das rückwärtige Gate eines jeden Transistors der zweiten Zelle angelegt wird und das zweite Ausgangssignal ($\overline{S}$) der zweiten Zelle an das rückwärtige Gate eines jeden Transistors der ersten Zelle angelegt wird;

wobei der Schaltkreis **dadurch gekennzeichnet ist, dass** das erste Ausgangssignal (S) der ersten Zelle mit einem Eingang einer ersten logischen Zelle eines anderen Schaltkreises mit Differenziallogik gleicher Konfiguration wie der Schaltkreis mit Differenziallogik verbunden ist; und

war das zweite Ausgangssignal ($\overline{S}$) der zweiten Zelle mit einem Eingang einer zweiten logischen Zelle dieses anderen Schaltkreises mit Differenziallogik verbunden ist.

2. Schaltkreis nach Anspruch 1, bei welchem die Transistoren Transistoren mit asymmetrischem rückwärtigem Gate sind.

3. Schaltkreis nach Anspruch 2, bei welchem die Transistoren Transistoren vom Typ CMOS sind.

4. Schaltkreis nach Anspruch 1, bei welchem die erste Zelle ein erster CMOS-Inverter ist, welcher in der Lage ist, einen gegenüber seinem Eingang umgekehrten Ausgang abzugeben, und die zweite Zelle ein zweiter CMOS-Inverter ist, welcher in der Lage ist, einen Eingang zu empfangen, welcher komplementär zum Eingang des ersten Inverters ist, und um einen Ausgang abzugeben, welcher komplementär zum Ausgang des ersten Inverters ist, wobei der Ausgang des ersten Inverters an das rückwärtige Gate der NMOS- und PMOS-Transistoren des zweiten CMOS-Inverters angelegt wird und der zum zweiten Inverter komplementäre Ausgang an das rückwärtige Gate der NMOS- und PMOS-Transistoren des ersten CMOS-Inverters angelegt wird.

5. Schaltkreis nach Anspruch 4, bei welchem der erste Inverter und der zweite Inverter direkt zwischen einer Hochspannung und einer Niederspannung verbunden sind.

6. Schaltkreis nach Anspruch 4, bei welchem der erste Inverter und der zweite Inverter einen Stromgenerator zwischen dem PMOS- Transistor und einer Hochspannung beinhalten.

7. Schaltkreis nach Anspruch 5 oder 6, bei welchem der erste Inverter und der zweite Inverter einen Stromgenerator zwischen dem NMOS- Transistor und einer Niederspannung beinhalten.

8. System, beinhaltend mehrere Schaltkreise nach einem der Ansprüche 1 bis 7, wobei die mehreren Schaltkreise zu einer Kette gekoppelt sind, so dass die Ausgänge eines Schaltkreises der Kette mit den Eingängen des nächsten Schaltkreises in der Kette verbunden sind.

9. System nach Anspruch 8, bei welchem die Eingangssignale im Wesentlichen gleichzeitige Übergänge aufweisen, wobei die Fortpflanzungszeiten im Wesentlichen gleich sind und die Ausgangssignale im Wesentlichen gleichzeitige Übergänge aufweisen.

10. System nach Anspruch 8 oder 9, beinhaltend eine gleichzahlige Anzahl an Schaltkreisen, wobei das System einen spannungsgeregelten Oszillator bildet.

11. System nach Anspruch 10, beinhaltend vier identische Ausgänge gleicher Amplitude, gleicher Frequenz und mit gleichmäßig verteilten Phasen.

12. Schaltkreis nach Anspruch 1, bei welchem die erste Zelle CMOS-Transistoren beinhaltet, welche in der Lage sind, eine AND-Funktion für zwei Eingänge (A,B) auszuführen und die zweite Zelle CMOS-Transistoren beinhaltet, welche in der Lage sind, eine AND-Funktion für die beiden komplementären Eingänge (A,B) der ersten Zelle auszuführen.

13. Schaltkreis nach Anspruch 1, bei welchem die erste Zelle CMOS-Transistoren beinhaltet, welche in der Lage sind, eine NAND-Funktion für zwei Eingänge (A,B) auszuführen und die zweite Zelle CMOS-Transistoren beinhaltet, welche in der Lage sind, eine NAND-Funktion für die beiden komplementären Eingänge (A,B) der ersten Zelle auszuführen.

14. Schaltkreis nach Anspruch 1, bei welchem die erste Zelle CMOS-Transistoren beinhaltet, welche in der Lage sind, eine OR-Funktion für zwei Eingänge (A,B) auszuführen und die zweite Zelle CMOS-Transistoren beinhaltet, welche in der Lage sind, eine OR-Funktion für die beiden komplementären Eingänge (A,B) der ersten Zelle auszuführen.

15. Schaltkreis nach Anspruch 1, bei welchem die erste Zelle CMOS-Transistoren beinhaltet, welche in der Lage sind, eine NOR-Funktion für zwei Eingänge (A,B) auszuführen und die zweite Zelle CMOS-Transistoren beinhaltet, welche in der Lage sind, eine NOR-Funktion für die beiden komplementären Eingänge (A,B) der ersten Zelle auszuführen.

16. Schaltkreis nach einem der Ansprüche 1 bis 7 und 12 bis 15, bei welchem die Transistoren Transistoren der Technologie vollständig verarmtes Silizium auf Isolator "FDSOI" sind.

17. Schaltkreis nach einem der Ansprüche 1 bis 7 und 12 bis 15, bei welchem die Transistoren Transistoren der Technologie "FinFet" mit doppeltem Gate sind.

**Claims**

1. Differential-logic circuit able to be chained with another differential-logic circuit having the same configuration, comprising:

   - a first logic cell composed of back-gate transistors, the first cell having at least one first input for receiving at least one first input signal (A) and having an output for delivering a first output signal (S); and
   - a second logic cell complementary to the first cell, composed of back-gate transistors, the second cell having as many inputs as the first cell, each input being able to receive an input signal ($\overline{A}$) complementary to the respective input signal of the first cell, the second cell having an output for delivering a second output signal ($\overline{S}$) complementary to the first output signal (S) of the first cell;

   said first output signal (S) of the first cell being applied to the back gate of each transistor of the second cell and said second output signal ($\overline{S}$) of the second cell being applied to the back gate of each transistor of the first cell; the circuit being **characterized in that** said first output signal (S) of the first cell is connected to an input of a first logic cell of another differential logic circuit of same configuration as said differential logic circuit; and said second output signal ($\overline{S}$) of the second cell is connected to an input of a second logic cell of this other circuit in differential logic.

2. Circuit according to Claim 1, in which the transistors are transistors with asymmetric back gate.

3. Circuit according to Claim 2, in which the transistors are of CMOS type.

4. Circuit according to Claim 1, in which the first cell is a first CMOS inverter able to deliver an output inverse to its input, and the second cell is a second CMOS inverter able to receive an input complementary to the input of the first inverter and to deliver an output complementary to the output of the first inverter, the output of the first inverter being applied to the back gate of the NMOS and PMOS transistors of the second CMOS inverter and the complementary output of the second inverter being applied to the back gate of the NMOS and PMOS transistors of the first CMOS inverter.

5. Circuit according to Claim 4, in which the first inverter and the second inverter are connected directly between a high voltage and a low voltage.

6. Circuit according to Claim 4, in which the first inverter and the second inverter comprise a current generator between the PMOS transistor and a high voltage.

7. Circuit according to Claim 5 or 6, in which the first inverter and the second inverter comprise a current generator between the NMOS transistor and a low voltage.

8. System comprising several circuits according to any one of Claims 1 to 7, the said several circuits being coupled as a chain so that the outputs of a circuit of the chain are connected to the inputs of the following circuit in the chain.

9. System according to Claim 8, in which the input signals exhibit substantially simultaneous transitions, the propagation times are substantially equal and the output signals exhibit substantially simultaneous transitions.

10. System according to Claim 8 or 9, comprising an even number of circuits, the system producing a voltage controlled oscillator.

11. Oscillator according to Claim 10, comprising four identical outputs of the same amplitude, of the same frequency and of regularly distributed phases.

12. Circuit according to Claim 1, in which the first cell comprises CMOS transistors able to carry out an AND function of two inputs (A,B) and the second cell comprises CMOS transistors able to carry out an AND function of the two complementary inputs (A,B) of the first cell.

13. Circuit according to Claim 1, in which the first cell comprises CMOS transistors able to carry out a NAND function of two inputs (A,B) and the second cell comprises CMOS transistors able to carry out a NAND function of the two complementary inputs (A,B) of the first cell.

14. Circuit according to Claim 1, in which the first cell comprises CMOS transistors able to carry out an OR function of two inputs (A,B) and the second cell comprises CMOS transistors able to carry out an OR function of the two complementary inputs (A,B) of the first cell.

15. Circuit according to Claim 1, in which the first cell comprises CMOS transistors able to carry out a NOR function of two inputs (A,B) and the second cell comprises CMOS transistors able to carry out a NOR function of the two complementary inputs (A,B) of the first cell.

16. Circuit according to any one of Claims 1 to 7 and 12 to 15, in which the transistors are transistors based on fully depleted silicon on insulator "FDSOI" technology.

17. Circuit according to any one of Claims 1 to 7 and 12 to 15, in which the transistors are double-gate "FinFet" transistors.

100

A ▷∘— S = $\overline{A}$

102

A —[ ]— S = $\overline{A}$

104

A —[ ]— S = $\overline{A}$

106

A —[ ]— S = $\overline{A}$

108

A —[ ]— S = $\overline{A}$

## FIG.1

$\overline{A}$ —▷∘— $\overline{S}$ = A

A ——— S = $\overline{A}$

200

## FIG.2

FIG.2

300-2

$V_{DD}$

314

316

318

$\overline{A}$ ——— $\overline{S}$ = A

312

$V_{SS}$

300

$V_{DD}$

304

306

308

A ——— S = $\overline{A}$

302

300-1

$V_{SS}$

## FIG.3

FIG.4

FIG.5

FIG.6

FIG.7a

FIG.7b

FIG.7c

FIG.7d

FIG.7e

**EP 3 079 260 B1**

## RÉFÉRENCES CITÉES DANS LA DESCRIPTION

**Documents brevets cités dans la description**

- US 2007262793 A1